# EUROPEAN PATENT SPECIFICATION

(11) **EP 3 928 985 B1**
(45) Date of publication and mention of the grant of the patent: **18.09.2024**
(21) Application number: 21173772.1
(22) Date of filing: 13.05.2021
(51) Int. Cl.: B41F 15/18, B41F 15/08, H01L 21/677, H01L 21/68, H05K 3/12

(54) **WORKPIECE ALIGNMENT AND PRINTING**
WERKSTÜCKAUSRICHTUNG UND -BEDRUCKEN
ALIGNEMENT ET IMPRESSION DE PIÈCE DE TRAVAIL

(30) Priority: 22.06.2020 GB 202009474
(43) Date of publication of application: 29.12.2021
(73) Proprietor: ASMPT SMT Singapore Pte. Ltd., Singapore 768924 (SG)
(72) Inventor: HANSFORD, Keith Michael, Weymouth, DT4 9TH (GB); KATSCHKE, Jens, D-61169 Friedberg (DE); LEE, Tsung-En, 23511 New Taipei City (TW)
(74) Representative: Emerson, Peter James

(56) References cited:
- WO-A1-2014/083605
- JP-A- 2009 248 551
- US-A- 6 066 206
- US-A1- 2008 289 518

## Description

This invention relates to a method of printing workpieces, a computer program for controlling a printing machine, a printing machine and a method of aligning a workpiece.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a printing screen (sometimes referred to as a mask, foil or stencil) using an angled blade or squeegee. The same machines may also be used to print certain non-conductive media, such as glue or other adhesive, onto workpieces.

To ensure high quality printing, it is necessary to support the workpiece so that the surface to be printed is parallel to the printing screen, generally horizontal, with the workpiece support being capable of withstanding the pressure placed upon it during the printing operation, especially by the downward pressure applied by the squeegee, while maintaining the correct alignment of the workpiece.

Where the area of the pattern is relatively small with respect to the area of the screen, it is possible to include more than one pattern within the screen, thus allowing more than one area of a board, or more than one board, to be printed simultaneously using the same screen. Alternatively, more than one relatively small screen may be used within the same printing machine to enable the more than one area of a board, or more than one board, to be printed simultaneously using respective screens.

A workpiece support assembly, capable of supporting and individually aligning a multiplicity of relatively small workpieces (commonly referred to as "singulated" workpieces) has been described in GB1900058.7. FIG. 1 schematically shows an example of such an assembly 1, here including a 2 x 4 array of individual support "towers" 2. Each tower 2 is topped with a support surface 3 upon which a workpiece (not shown) may be supported during a printing operation. Furthermore, each tower 2 is individually actuable to move in orthogonal directions X and Y, which would typically be in the horizontal plane, and also to rotate about an orthogonal Z axis, which would typically extend in the vertical direction to provide so-called theta correction. As described in GB1900058.7, such movement may be advantageously provided through the use of a parallel kinematic actuation system within each tower. Other arrays of greater or smaller dimension are of course possible.

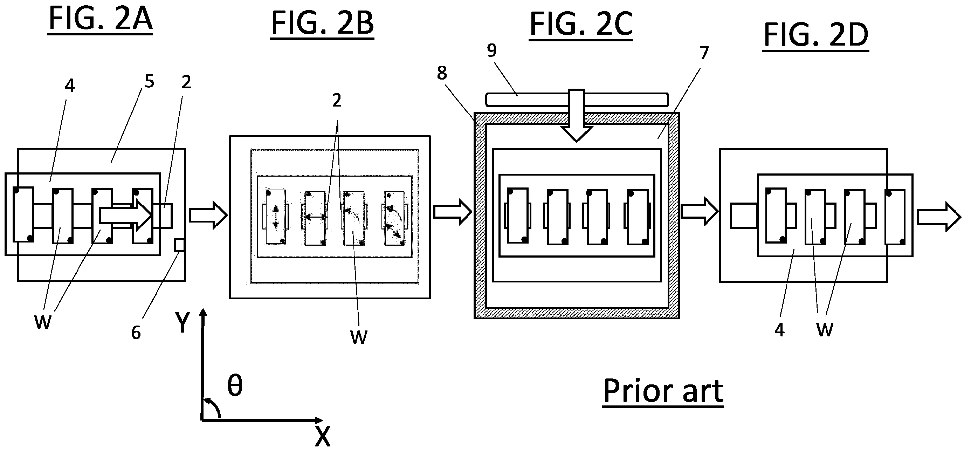

Typically, when printing singulated workpieces, a plurality of the workpieces will be located in a carrier, and the workpieces will be moved through the printing machine, and indeed between different machines along an assembly line, within the carrier. FIGs. 2A-D schematically show, from above, the following basic steps which may be performed. In FIGs. 2A-D, for simplicity a workpiece support assembly having a 1x4 tower array is shown.
i) As shown in FIG. 2A, a carrier 4, retaining a multiplicity of workpieces W therein, is transported into a printing machine (not shown) in the horizontal X-direction using a conveyor (not shown), and aligned within the printing machine by abutting it against a physical stop element 6, so that the workpieces W are located directly above respective towers 2 of a workpiece support assembly on a rising table 5;
ii) the towers 2 and respective overlying workpieces W are brought into contact, for example by lifting rising table 5 which carries the workpiece support assembly, so that the workpieces W are lifted from the carrier 4;
iii) as shown in FIG. 2B, each workpiece W is aligned as necessary by suitable actuation of the respective underlying towers 2 in the X, Y and theta directions;
iv) the workpieces W are brought into contact with a patterned printing screen 7 (shown transparently for clarity in FIG. 2C), through further lifting of the rising table 5, the printing screen 7 being tensioned within a frame 8;
v) as shown in FIG. 2C, a print stroke is performed, using a squeegee 9 to deposit print medium onto the workpieces W through the apertures of the printing screen 7;
vi) the workpieces W are brought out of contact with the printing screen 7 and returned to the carrier 4, by lowering the rising table 5; and
vii) as shown in FIG. 2D, the physical stop element 6 is moved out of engagement with the carrier 4, and the carrier 4, with its workpieces W, is transported out of the printing machine along the horizontal X direction.

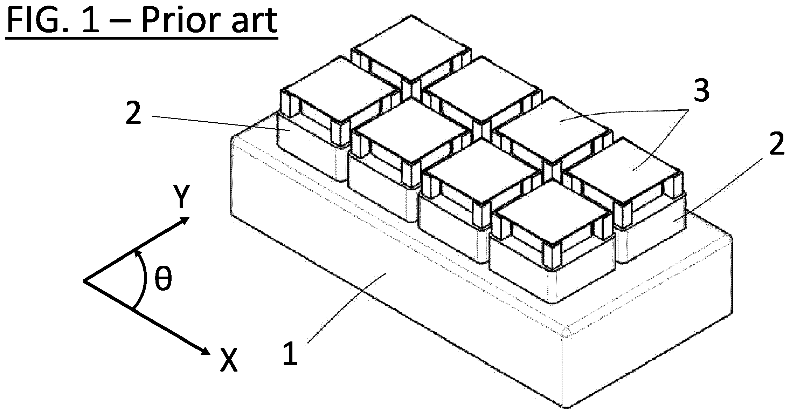

Those skilled in the art will recognise that in order to function as intended, the individual towers of an array such as that shown in FIG. 1 must have a certain minimum spacing therebetween (i.e. the "pitch" of the array), so that each tower may move and / or rotate freely, without risk of collision with an adjacent tower in the array.

When using a carrier loaded with singulated substrates, such a system generally works well, however there are some problems and restrictions faced when using such apparatus. For example:
i) some users of printing machines may wish to print singulated workpieces located in a carrier in which the pitch of adjacent workpieces on a carrier is smaller than the corresponding pitch of the array;
ii) operational flexibility and throughput is restricted, since only the workpieces on a single carrier can be printed in a single print stroke; and
ii) for certain applications it may be preferable to print singulated workpieces without a carrier.

The present invention seeks to overcome these restrictions in a cost-effective and robust manner.

In accordance with the present invention, this aim is achieved by providing a more flexible stopping arrangement, and thereby selectively controlling the position of carriers within the printing machine.

Hereafter, a workpiece support system comprising an array of at least two discrete support surfaces, each support surface for supporting a workpiece thereon in use, will be termed a "multiple support system". One example of a multiple support system is a "multiple tower support system", in which each support surface is located on a respective tower, such as described in GB1900058.7 for example. Other types of multiple tower support system exist, for example those in which parallel kinematics actuation is not used, or indeed multiple tower support systems in which the individual towers are not capable of the movement within any or all of the X, Y and theta (θ) directions, and an example of such a system is described in WO2014166956A1 for example. However, other types of multiple support system are possible which do not comprise towers, including for example a simple table with an upper support surface, the upper support surface including an array of regions each dedicated to supporting a respective workpiece, such that each region constitutes a support surface. It should also be understood that each support surface need not be flat, but could for example be contoured so as to support non-planar workpieces, or have a plurality of pins extending therefrom to support the underside of workpieces which have features located on the underside thereof which cannot contact a support surface directly, such as placed electronics components, holes or vias.

As background art may also be mentioned:
WO2014083605, US2008289518, JP2009248551 relate to printing workpieces in printing machines; and
iv) US-A-6066206 - this document relates to a dual track stencil system.

### Summary of the invention

In accordance with a first aspect of the present invention there is provided a method for printing workpieces having a first pitch along a horizontal transport path using a printing machine, the printing machine comprising:
a rising table being vertically movable between a lower, retracted position and an upper, extended position, and
tooling fitted to the rising table to be carried therewith, the tooling comprising a plurality of discrete and horizontally spaced support surfaces,
the arrangement being such that in use workpieces are conveyed into and through the printing machine along the horizontal transport path, which is vertically above the tooling when the rising table is in the retracted position, and a support surface may be brought into engagement with a workpiece by raising the rising table toward the extended position, to enable a printing operation to be performed to print the engaged workpiece,
the method comprising transporting a plurality of workpieces to be printed into the printing machine along the horizontal transport path,
characterised in that the plurality of support surfaces are spaced along the horizontal transport path at a second pitch which is greater than the first pitch, and the transport is controlled such that each workpiece of the plurality of workpieces is stopped at respective first and second locations within the printing machine, the first and second locations being spaced along the horizontal transport path and each being located directly above the rising table when in its retracted position, with at least one of the first and second locations being directly located above a support surface of the tooling.

In accordance with a second aspect of the present invention there is provided a computer program for controlling a printing machine to perform the method of the first aspect.

In accordance with a third aspect of the present invention there is provided a printing machine for printing workpieces having a first pitch along a horizontal transport path, comprising:
a rising table being vertically movable between a lower, retracted position and an upper, extended position,
tooling fitted to the rising table to be carried therewith, the tooling comprising a plurality of discrete and horizontally spaced support surfaces,
a conveyor operable to transport workpieces into and through the printing machine along the horizontal transport path which is vertically above the tooling when the rising table is in the retracted position, and
characterised in that the plurality of support surfaces are spaced along the horizontal transport path at a second pitch which is greater than the first pitch, and
characterised by a transport control system operable to selectively stop a workpiece on the conveyor at either a first or a second location within the printing machine, the first and second locations being spaced along the horizontal transport path and each being located directly above the rising table when in its retracted position, with at least one of the first and second locations being directly located above a support surface of the tooling.

In accordance with a fourth aspect of the present invention there is provided a method for aligning a workpiece for printing within a printing machine, the printing machine comprising:
a rising table being vertically movable between a lower, retracted position and an upper, extended position, and
tooling fitted to the rising table to be carried therewith, the tooling comprising a plurality of discrete and horizontally spaced support surfaces, wherein the tooling comprises a plurality of towers, each support surface of the plurality of support surfaces being located at an upper end of a respective tower, and each support surface is moveable within the horizontal plane, and wherein each tower is individually actuable to translate its support surface both parallel to the horizontal path and orthogonally to the horizontal path within the horizontal plane, and rotate the support surface about a respective vertical axis,
characterised in that the method comprises the steps of:
   i) transporting a workpiece into and through the printing machine along a horizontal transport path,
   ii) stopping the workpiece at a location in which the workpiece directly overlies first and second support surfaces of the plurality of support surfaces,
   iii) bringing the workpiece into engagement with both the first and second support surfaces, and
   iv) aligning the workpiece by moving the first and second support surfaces while engaged with the workpiece.

Other specific aspects and features of the present invention are set out in the accompanying claims.

### Brief Description of the Drawings

The invention will now be described with reference to the accompanying drawings (not to scale), in which:
FIG. 1 schematically shows a known multiple tower support system;
FIGs. 2A-D schematically show a printing operation for a known tower support system;
FIGs. 3A and 3B schematically show a first step in a method according to the present invention from above and in a sectional side view respectively;
FIGs. 3C and 3D schematically show a second step in a method according to the present invention from above and in a sectional side view respectively;
FIGs. 4A and 4B schematically show another method according to the present invention, from above and in a sectional side view respectively;
FIGs. 5A and 5B schematically show a further method according to the present invention, from above and in a sectional side view respectively;
FIGs. 6A and 6B schematically show a yet further method according to the present invention, from above and in a sectional side view respectively; and
FIG. 7 schematically shows a workpiece and support surfaces from above, illustrating a movement scheme therefor.

### Detailed Description of the Preferred Embodiments of the Invention

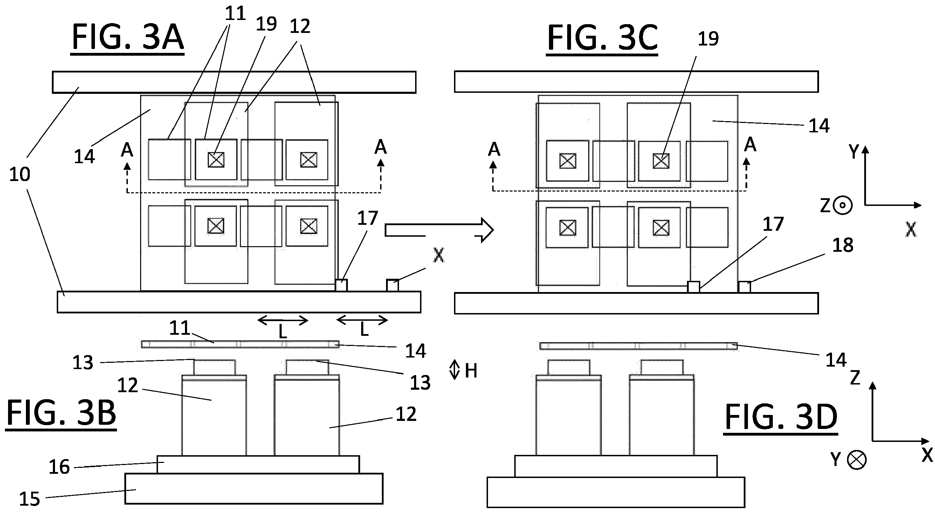

An embodiment of the present invention is schematically shown with reference to FIGs. 3A-D. These show the interior of a printing machine from above (FIGs. 3A and 3C), and in a sectional side view along the section A-A (FIGs. 3B and 3D), and are aligned so that stationary components, such as towers 12, are shown at the same X-position and scale throughout the four figures.

FIG. 3A schematically shows, from above, a printing area within a printing machine. Rails 10 are provided within the machine which define a horizontal transport path therebetween. The rails 10 may conveniently be provided with respective conveyors (not shown) to convey articles, in this case a carrier 14, along the transport path in the direction shown by the large arrow, which is generally denoted the X-direction in the art. Therefore, it is to be understood that the horizontal plane is equivalent to the X-Y plane as shown, while "Z" denotes the vertical direction. As will be recognised by those skilled in the art, rails 10 are usually relatively moveable in the Y direction, so that articles of differing widths may be carried therebetween. For clarity, the carrier 14 is shown transparently, so that the positioning of components underneath the carrier 14 can be seen. The carrier 14 shown in this embodiment includes eight workpiece receptacles 11, in a four by two matrix. Hereafter, each line of two adjacent workpiece receptacles 11 which lie in the same X position will be referred to as "columns", so that here, four columns are shown, with, for convenience, the leftmost column referred to as the "first column", and the rightmost column as the "fourth column" for example. Each workpiece receptacle 11 is designed to carry a single singulated workpiece (not shown for clarity). In order to print a pattern 19 onto a workpiece, it is necessary to align a workpiece receptacle, and hence its received workpiece, above the support surface 13 (see FIG. 3B) of a tower 12 of tooling (a multiple tower support system) arranged below the horizontal transport path. The patterns 19 are formed in a stencil or screen (not shown) located above the horizontal transport path. As shown in FIG. 3A, in this embodiment four towers 12 are provided, in a two-by-two matrix.

As most clearly seen in FIG. 3B, each tower 12 is provided with a support surface 13 at an upper end thereof for engaging with a respective workpiece in use, with the support surfaces 13 being discrete and horizontally spaced. For clarity, the support surfaces 13 are shown as being flat, but in fact these may be contoured or profiled so as to support non-flat workpieces thereon in use. The towers 12 are provided on a tooling unit 16, which in turn is mounted on a rising table 15. The rising table 15 is vertically-movable between a lower, retracted position (shown in FIG. 3B) and an upper, extended position (not shown), with the vertical distance travelled being shown as "H" in FIG. 3B, in which the support surfaces 13 are brought up and into engagement with their overlying workpieces, to lift the workpieces away from the carrier 14. In this extended position, a printing operation may be performed to print the engaged workpieces. The support surfaces 13 are of smaller horizontal dimension than their respective towers 12, and are small enough to be able to project within a workpiece receptacle located directly above a respective tower 12 during raising of the rising table 15 to the extended position.

In a preferred embodiment, the support surfaces 13 of each tower 12 are moveable within the horizontal or X-Y plane, upon receipt of suitable control signals received via the tooling unit 16. Yet more preferably, each support surface 13 is translatable both parallel to the horizontal path and orthogonally to the horizontal path within the horizontal or X-Y plane, and rotatable about a respective vertical or Z axis, similarly to the workpiece support assembly 1 shown in FIGs. 1 and 2.

As can be most clearly seen in FIG. 3A, the individual workpiece receptacles 11 have a relatively small pitch of length L in the X direction, while the towers 12 have a relatively large pitch in the X direction, and so it is impossible to locate all workpieces above respective support surfaces 13 at once. In accordance with the present invention, this problem is solved by enabling the carrier 14, and hence any workpieces carried thereby, to be stopped in more than one location along the X direction. In the embodiment shown, a first physical stop 17 is provided proximate the rails to stop the carrier 14 at a first location along the horizontal path, in which workpieces carried in the second and fourth workpiece receptacle columns of the matrix directly overlie respective support surfaces 13, as shown in FIGs. 3A and 3B. The workpieces carried in the first and third workpiece receptacle columns of the matrix do not align with any support surfaces 13, but do overlie the rising table 15. In this position, the rising table 15 may be raised so that the support surfaces 13 engage with the workpieces in the second and fourth columns of the carrier 14. Once engaged and lifted from the carrier 14, the workpieces may be aligned by suitable movement of the support surfaces 13 in the X-Y plane, and then printed with respective print patterns 19. The rising table 15 is then lowered back to the retracted position, so that printed workpieces are returned to their respective workpiece receptacles 11 in carrier 14.

The carrier 14 is then transported to a second position which is a length L in the X direction, i.e. corresponding to the pitch of the workpiece receptacles 11. The carrier 14 is stopped at this second position by a second physical stop 18, so that it is stopped at the position shown in FIGs. 3C and 3D. Although not clearly shown, both the first and second physical stops 17, 18 are retractable, so that they can be moved in and out of the horizontal path, to selectively stop the carrier 14 at either the first or second position. Controllable physical stops are known in the art per se, and so need not be described further here, but typically comprises an arm, rod or other barrier which may be selectively pivoted or translated into and out of the horizontal path by means of an actuator controlled by a processor, computer or other control means.

As shown in FIGs. 3C and 3D, at this second location along the horizontal path, workpieces carried in the first and third workpiece receptacle columns of the matrix directly overlie respective support surfaces 13. The previously-printed workpieces carried in the second and fourth workpiece receptacle columns of the matrix do not align with any support surfaces 13, but do overlie the rising table 15. In this position, the rising table 15 may be raised so that the support surfaces 13 engage with the workpieces in the first and third columns of the carrier 14. Once engaged and lifted from the carrier 14, the workpieces may be aligned by suitable movement of the support surfaces 13 in the X-Y plane, and then printed with respective print patterns 19. The rising table 15 is then lowered back to the retracted position, so that the recently printed workpieces are returned to their respective workpiece receptacles 11 in carrier 14. The carrier 14, with its completely printed workpieces, may then be transported out of the printing machine along the horizontal transport path in the X-direction.

The concept may be extended to allow efficient printing of carriers having workpiece receptacles at yet smaller pitches. For example, if a carrier having a six-by-two array of workpiece receptacles was used, and the pitch between workpiece receptacles was a third of the pitch between support surfaces, then all workpieces of the carrier could be printed in three print operations. In this case, preferably by printing columns three and six first, then moving the carrier forward by one pitch and printing columns two and five, then moving the carrier forward another one pitch and printing columns one and four.

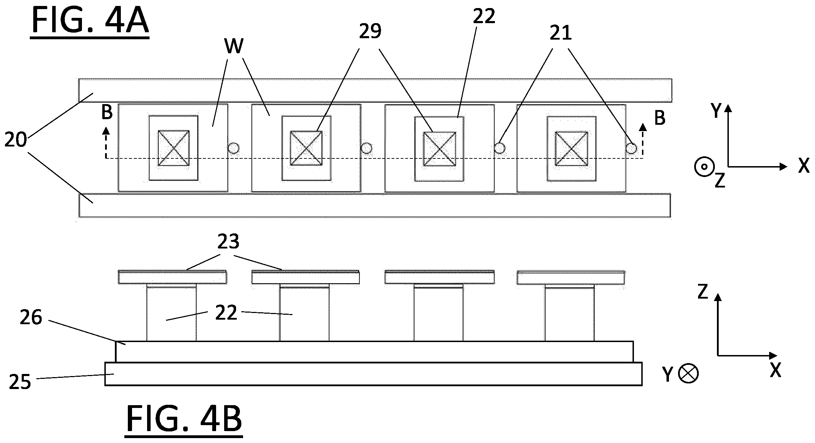

Another embodiment of the present invention is schematically shown with reference to FIGs. 4A and 4B. The method described here enables a plurality of workpieces W, which are not retained within a carrier, to be printed in a single printing operation. FIG. 4A shows the interior of a printing machine from above, while FIG. 4B shows this in a sectional side view along the line B-B. Many components shown are similar to those previously described, and so need not be described at length here. Rails 20 define a horizontal transport path therebetween for carrierless workpieces W, with four workpieces W being shown. With such a configuration, the workpieces W are directly supported by, and conveyed along, rails 20. This naturally restricts the workpieces W to enter the printing machine one at a time, and so for this embodiment a tooling unit 26 is provided which carries a plurality of towers 22 in a four-by-one matrix, with each tower 22 having a support surface 23 at an upper end thereof, the support surfaces being dimensioned and profiled as necessary to adequately support a workpiece W thereon. The tooling unit 26 is mounted onto rising table 25.

In order to improve printing efficiency, it is possible, in accordance with the present invention, to print four separate singulated workpieces W with a printing pattern 29 in a single printing operation. This benefit is enabled by providing four separate physical stop elements 21 along the horizontal transport path, each selectively operable to stop a respective workpiece W directly above a respective support surface 23. The physical stop elements 21 are operated under control of a control system (not shown), such as a computer, processor or the like.

The tooling (i.e. tooling unit 26, towers 22 and support surfaces 23) and rising table 25 operate in an identical manner as in the previously-described embodiment. When the rising table 25 is raised to its extended position, each support surface 23 engages with its respective overlying workpiece W and lifts it away from the rails 20. Following any alignment of the workpiece W, for example by movement of the support surface 23 in the X-Y plane, the workpieces are printed in a single print operation, and then may be returned to the rails 20 by lowering of the rising table 25 back to the retracted position.

Since the physical stop elements 21 are selectively operable, workpieces W can be prevented from stopping above support surfaces 23 of damaged or non-functional towers 22, for example, but instead stopped above an adjacent, fully functional, support surface 23.

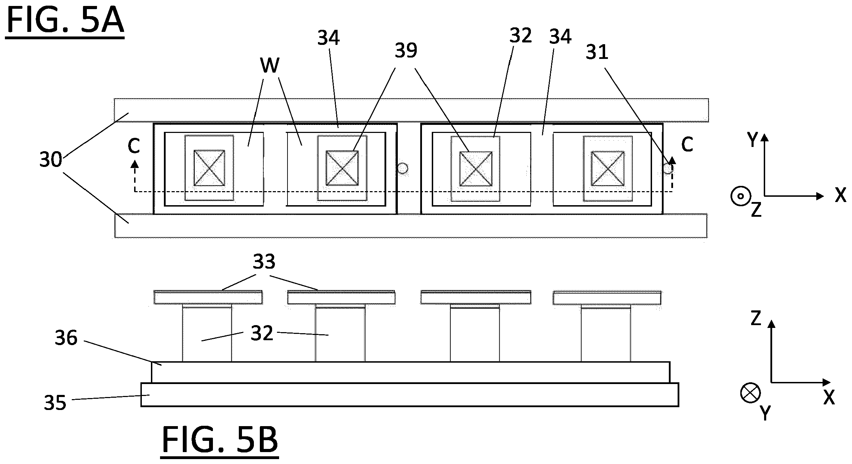

Another embodiment of the present invention is schematically shown with reference to FIGs. 5A and 5B. This is quite similar to that shown in FIGs. 4A and 4B, however here, rather than the workpieces W being directly supported by rails, they are placed in carriers, with all the workpieces of a plurality of carriers being printable in a single printing operation.

FIG. 5A shows the interior of a printing machine from above, while FIG. 5B shows this in a sectional side view along the line C-C. Many components shown are similar to those previously described, and so need not be described at length here. Rails 30 define a horizontal transport path therebetween for carriers 34, with two carriers 34 being shown. Within each carrier 34, two singulated workpieces W may be carried, here shown in a one-by-two array. Other configurations are possible, for example each carrier 34 may be adapted to carry a plurality of workpieces in a non-linear array, such as two-by-two. While as shown, a tooling unit 36 is provided which carries a plurality of towers 32 in a four-by-one matrix, with each tower 32 having a support surface 33 at an upper end thereof, the support surfaces being dimensioned and profiled as necessary to adequately support a workpiece W thereon, other configurations of tooling are possible, if, for example, each carrier 34 carries workpieces W in a non-linear array. The tooling unit 36 is mounted onto rising table 35. With such a configuration, the carriers 34 are directly supported by, and conveyed along, rails 30, with carriers 34 able to enter the printing machine one at a time.

In order to improve printing efficiency, it is possible, in accordance with the present invention, to print the four separate singulated workpieces W carried by the two carriers 34 with a printing pattern 39 in a single printing operation. This benefit is enabled by providing two separate physical stop elements 31 along the horizontal transport path, each selectively operable to stop a respective carrier 34 so that each of its workpieces W stop directly above a respective support surface 33. The physical stop elements 31 are operated under control of a control system (not shown), such as a computer, processor or the like.

This embodiment may also be combined with the embodiment shown in FIGs. 3A- 3D, so that more than one carrier 34 may be introduced into the printing area above the rising table 35, each carrier 34 carrying workpieces W at a smaller pitch than the pitch between support surfaces 33. In this case, additional stop elements would be required so that each carrier 34 could be stopped at a distance forward along the horizontal transport path equal to one workpiece pitch. Alternate columns of all carriers 34 would be printed in a single print operation, with the remaining columns printed in a second print operation.

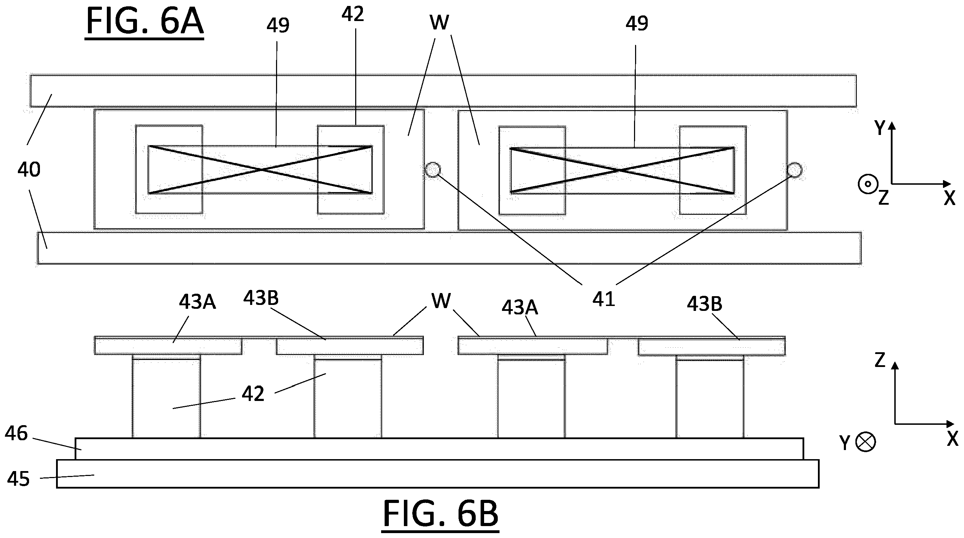

Another embodiment of the present invention is schematically shown with reference to FIGs. 6A and 6B. Here the arrangement is generally similar to that shown in FIGs. 4A and 4B, with carrierless workpieces W supported and conveyed directly by rails 40. In this case however, the workpieces W are relatively large, so that each may directly overlie first and second adjacent support surfaces 43A, 43B of tooling of a multiple tower support system. The printing patterns 49 shown are correspondingly large.

In order to improve printing efficiency, it is possible, in accordance with the present invention, to print two separate singulated workpieces W with a printing pattern 49 in a single printing operation. This benefit is enabled by providing two separate physical stop elements 41 along the horizontal transport path, each selectively operable to stop a respective workpiece W directly above first and second support surfaces 43A, 43B. The physical stop elements 41 are operated under control of a control system (not shown), such as a computer, processor or the like.

The tooling (i.e. tooling unit 46, towers 42 and support surfaces 43A, 43B located at upper ends of respective towers 42) and rising table 45 operate in an identical manner as in the previously-described embodiments. When the rising table 45 is raised to its extended position, each support surface 43 engages with its respective overlying workpiece W and lifts it away from the rails 40. In this embodiment, alignment of the workpieces W is then performed, by moving the first and second support surfaces 43A, 43B while engaged with the overlying workpiece W. In particular, alignment is performed through coordinated movement of the support surfaces 43A, 43B in the horizontal or X-Y plane. This is particularly beneficial when using support surfaces 43A, 43B which are translatable both parallel to the horizontal path and orthogonally to the horizontal path within the horizontal plane, and rotatable about a respective vertical or Z axis. The workpieces W may then be printed in a single print operation, de-aligned (i.e. returned to the positions at which they arrived above the rising table 45) if necessary and then returned to the rails 40 by lowering of the rising table 45 back to the retracted position.

Since the physical stop elements 41 are selectively operable, workpieces W can be prevented from stopping above support surfaces 43A, 43B of damaged or non-functional towers 42, for example, but instead stopped above alternative fully functional, support surfaces 43A, 43B.

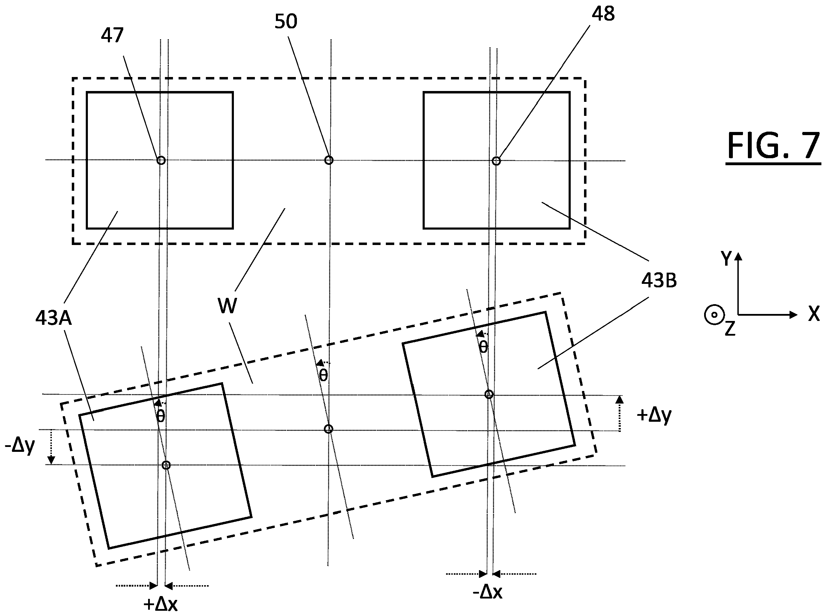

FIG. 7 schematically shows how the first and second support surfaces 43A, 43B may be used to co-operatively align an overlying workpiece W. The top part of FIG. 7 shows, from above, a workpiece W (made transparent for clarity) in a first orientation, supported at each end thereof by respective support surfaces 43A and 43B. The geometric centre of workpiece W is shown as 50, while the geometric centres of support surfaces 43A and 43B are shown at 47 and 48 respectively. The lower part of FIG. 7 shows, again from above, the positioning of workpiece W and support surfaces 43A, 43B if the workpiece W is caused to rotate by an angle θ about a vertical or Z axis passing through its centre 50, in an anticlockwise direction as shown. It is important that each support surface 43A, 43B cannot move relative to the overlying workpiece W, since to do so may cause damage to the workpiece W or any features present on its underside. The dashed lines show how the relative positions of the workpiece W and support surfaces 43A, 43B change with this rotation. It can be seen that the support surfaces 43A, 43B can be used to effect this rotation if the following conditions are met:
i) both first and second support surfaces 43A, 43B must also be rotate by θ in an anticlockwise direction,
ii) simultaneously, support surface 43A must move a distance Δx in the X direction and a distance Δy in the negative Y direction, and
iii) simultaneously, support surface 43B must move a distance Δx in the negative X direction and a distance Δy in the Y direction.

The required movements of support surfaces 43A and 43B are possible using a "multiple tower support system", such as that described in GB1900058.7 for example. While FIG. 7 only shows a rotation of workpiece W, it is of course also possible to cause a translation of workpiece W in the X-Y plane, by moving first and second support surfaces 43A and 43B an identical distance (i.e. moving in tandem) in the required direction of translation. Moreover, a combined rotation and translation of workpiece W is possible by superposing such movements.

While the embodiment described in FIG. 7 uses adjacent support surfaces 43A and 43B which are spaced in the X direction, i.e. along the horizontal transport path, to enable cooperative alignment, similar alignment is possible if the adjacent support surfaces are instead spaced in the Y direction, i.e. orthogonal to the horizontal transport path. Such an arrangement is useful where the workpieces are relatively long in the Y direction so as to span the two adjacent support surfaces.

In an alternative embodiment, the workpieces to be printed could be carried within a carrier.

It should be noted that the concept of aligning workpieces by placing them on two spatially-separated support surfaces, as generally described with reference to FIGs. 6A, 6B and 7 need not require the workpieces to be stopped at respective first and second locations within the printing machine. For example, a single two-tower tooling could be used to align a single, relatively large, workpiece.

The above-described embodiments are exemplary only, and other possibilities and alternatives within the scope of the invention will be apparent to those skilled in the art. For example, while the above-described embodiments use physical stop elements, it is equally possible to use a transport control system comprising a conveyor control operable to control the operation of the conveyor to bring a workpiece to a stop at a selected location above the rising table. In such a case, the transport control system may for example comprise a sensor associated with each of the first and second locations to sense the presence of a workpiece on the conveyor upstream of the respective location and pass a signal indicative of such presence to the conveyor control. In this way, full and flexible control of the workpieces and their stopping locations is enabled.

The methods described herein may be used with various sized arrays of workpieces and support surfaces. For example, the support surfaces, and respective towers, may be arranged in a wide range of n x m arrays in which "n" refers to the support surfaces spaced along the horizontal transport path or X direction and "m" refers to the support surfaces spaced orthogonal to that horizontal transport path, i.e. along the Y direction. In respect of the embodiments described with reference to FIGs. 3 to 6, any size array is possible in which n >= 2 and m >= 1. In respect of the embodiment described with reference to FIG. 7, any size array is possible in which either n or m >= 1 and the other of m and n >= 2.

### Reference numerals used:

1- Workpiece support assembly
2, 12, 22, 32, 42 - Tower
3, 13, 23, 33, 43A, 43B - Support surface
4, 14, 34 - Carrier
5, 15, 25, 35, 45 - Rising table
6 - Physical stop element
7 - Printing screen
8 - Frame
9 - Squeegee
10, 20, 30, 40 - Rails
11- Workpiece receptacles
16, 26, 36, 46 - Tooling unit
17 - First physical stop
18 - Second physical stop
19, 29, 39, 49 - Print pattern
21, 31, 41 - Physical stop elements
47 - Centre of support surface 43A
48 - Centre of support surface 43B
50 - Centre of workpiece W
H - Height
L - Length
W - Workpiece

## Claims

1. A method for printing workpieces (W) having a first pitch along a horizontal transport path using a printing machine, the printing machine comprising:
a rising table (15, 25, 35, 45) being vertically movable between a lower, retracted position and an upper, extended position, and
tooling (16, 26, 36, 46) fitted to the rising table (15, 25, 35, 45) to be carried therewith, the tooling (16, 26, 36, 46) comprising a plurality of discrete and horizontally spaced support surfaces (13, 23, 33, 43A, 43B),
the arrangement being such that in use workpieces (W) are conveyed into and through the printing machine along the horizontal transport path, which is vertically above the tooling (16, 26, 36, 46) when the rising table (15, 25, 35, 45) is in the retracted position, and a support surface (13, 23, 33, 43A, 43B) may be brought into engagement with a workpiece (W) by raising the rising table (15, 25, 35, 45) toward the extended position, to enable a printing operation to be performed to print the engaged workpiece (W),
the method comprising transporting a plurality of workpieces (W) to be printed into the printing machine along the horizontal transport path,
wherein the plurality of support surfaces are spaced along the horizontal transport path at a second pitch which is greater than the first pitch, and
the transport is controlled such that each workpiece (W) of the plurality of workpieces (W) is stopped at respective first and second locations within the printing machine, the first and second locations being spaced along the horizontal transport path and each being located directly above the rising table (15, 25, 35, 45) when in its retracted position, with at least one of the first and second locations being directly located above a support surface (13, 23, 33, 43A, 43B) of the tooling (16, 26, 36, 46).

2. The method of claim 1, wherein the workpieces (W) to be printed include at least one workpiece (W) in a first array, and at least one workpiece (W) in a second array, the workpieces (W) of the first and second arrays being interleaved along the horizontal transport path, the method comprising the steps of:
i) controlling the transport to move the plurality of workpieces (W) along the horizontal transport path and stop a workpiece (W) of the first array at a first respective location in which it directly overlies a support surface (13, 23, 33, 43A, 43B), and stop a workpiece (W) of the second array at a first respective location in which it directly overlies the rising table (15, 25, 35, 45) but not a support surface (13, 23, 33, 43A, 43B),
ii) raising the rising table (15, 25, 35, 45) to bring the workpiece (W) of the first array into engagement with its underlying support surface (13, 23, 33, 43A, 43B),
iii) performing a first print operation to print the engaged workpiece (W) of the first array,
iv) lowering the rising table (15, 25, 35, 45) to bring the printed workpiece (W) of the first array out of engagement with the support surface (13, 23, 33, 43A, 43B),
v) controlling the transport to move the plurality of workpieces (W) along the horizontal transport path and stop the workpiece (W) of the second array at a second respective location in which it directly overlies a support surface (13, 23, 33, 43A, 43B), and stop the workpiece (W) of the first array at a second respective location in which it directly overlies the rising table (15, 25, 35, 45) but not a support surface (13, 23, 33, 43A, 43B),
vi) raising the rising table (15, 25, 35, 45) to bring the workpiece (W) of the second array into engagement with its underlying support surface (13, 23, 33, 43A, 43 B),
vii) performing a second print operation to print the engaged workpiece (W) in the second array, and
viii) lowering the rising table (15, 25, 35, 45) to bring the printed workpiece (W) of the second array out of engagement with the support surface (13, 23, 33, 43A, 43B).

3. The method of claim 2, wherein a workpiece (W) of the first array and a workpiece (W) of the second array are conveyed into the printing machine on a common carrier (14, 34), and in step i) the carrier (14, 34) is transported to a first carrier location along the horizontal transport path, and in step v) the carrier (14, 34) is transported to a second carrier location along the horizontal transport path.

4. The method of claim 1, wherein a plurality of stopping locations are provided along the horizontal transport path, and the transport is controlled such that each workpiece (W) is stopped at a selected respective stopping location; optionally a workpiece (W) is stopped at each stopping location, and a single printing operation is performed to print every workpiece (W) which is stopped at a stopping location.

5. The method of any preceding claim, wherein the tooling (16, 26, 36, 46) comprises a plurality of towers (12, 22, 32, 42), each support surface (13, 23, 33, 43A, 43B) being located at an upper end of a respective tower (12, 22, 32, 42), and each support surface (13, 23, 33, 43A, 43B) is moveable within the horizontal plane.

6. The method of claim 5, wherein each support surface (13, 23, 33, 43A, 43B) is translatable both parallel to the horizontal path and orthogonally to the horizontal path within the horizontal plane, and rotatable about a respective vertical axis.

7. The method of either of claims 5 and 6, comprising stopping a workpiece (W) at a first location in which it directly overlies first and second support surfaces, such that raising of the rising table (15, 25, 35, 45) toward the extended position brings both the first and second support surfaces (13, 23, 33, 43A, 43B) into engagement with the workpiece (W).

8. The method of claim 7, comprising the step of adjusting the position and / or rotation of the workpiece (W) by moving the first and second support surfaces (13, 23, 33, 43A, 43B) when engaged with the workpiece (W).

9. A computer program for controlling a printing machine to perform the method of any preceding claim.

10. A printing machine for printing workpieces (W) having a first pitch along a horizontal transport path, comprising:
a rising table (15, 25, 35, 45) being vertically movable between a lower, retracted position and an upper, extended position,
tooling fitted to the rising table (15, 25, 35, 45) to be carried therewith, the tooling comprising a plurality of discrete and horizontally spaced support surfaces (13, 23, 33, 43A, 43B),
a conveyor operable to transport workpieces into and through the printing machine along the horizontal transport path, which is vertically above the tooling when the rising table (15, 25, 35, 45) is in the retracted position, and
wherein the plurality of support surfaces are spaced along the horizontal transport path at a second pitch which is greater than the first pitch, and
the printing machine further comprising a transport control system operable to selectively stop a workpiece (W) on the conveyor at either a first or a second location within the printing machine, the first and second locations being spaced along the horizontal transport path and each being located directly above the rising table (15, 25, 35, 45) when in its retracted position, with at least one of the first and second locations being directly located above a support surface (13, 23, 33, 43A, 43B) of the tooling.

11. The printing machine of claim 10, wherein the transport control system comprises:
a first physical stop element (17) operable to stop a workpiece (W) at the first location, and
a second physical stop element (18) operable to stop a workpiece (W) at the second location.

12. The printing machine of claim 10, wherein the transport control system comprises:
a conveyor control operable to control the operation of the conveyor to bring a workpiece (W) to a stop at a selected one of the first and second locations.

13. The printing machine of claim 12, wherein the transport control system comprises:
a sensor associated with each of the first and second locations to sense the presence of a workpiece (W) on the conveyor upstream of the respective location and pass a signal indicative of such presence to the conveyor control.

14. A method for aligning a workpiece (W) for printing within a printing machine, the printing machine comprising:
a rising table (45) being vertically movable between a lower, retracted position and an upper, extended position, and
tooling (46) fitted to the rising table (45) to be carried therewith, the tooling (46) comprising a plurality of discrete and horizontally spaced support surfaces (43A, 43B), wherein the tooling (46) comprises a plurality of towers (42), each support surface of the plurality of support surfaces (43A, 43B) being located at an upper end of a respective tower (42), and each support surface (43A, 43B) is moveable within the horizontal plane, and wherein each tower (42) is individually actuable to translate its support surface (43A, 43B) both parallel to the horizontal path and orthogonally to the horizontal path within the horizontal plane, and rotate the support surface (43A, 43B) about a respective vertical axis,
wherein the method comprises the steps of:
i) transporting a workpiece (W) into and through the printing machine along a horizontal transport path,
ii) stopping the workpiece (W) at a location in which the workpiece (W) directly overlies first and second support surfaces of the plurality of support surfaces (43A, 43B),
iii) bringing the workpiece (W) into engagement with both the first and second support surfaces (43A, 43B), and
iv) aligning the workpiece (W) by moving the first and second support surfaces (43A, 43B) while engaged with the workpiece (W).

## Patentansprüche

1. Verfahren zum Bedrucken von Werkstücken (W) mit einem ersten Abstand entlang eines horizontalen Transportpfades unter Verwendung einer Druckmaschine, die Druckmaschine umfassend:
einen höhenverstellbaren Tisch (15, 25, 35, 45), der vertikal zwischen einer unteren, eingefahrenen Position und einer oberen, ausgefahrenen Position beweglich ist, und
Werkzeug (16, 26, 36, 46), das an dem höhenverstellbaren Tisch (15, 25, 35, 45) angebracht ist, um damit getragen zu werden; wobei das Werkzeug (16, 26, 36, 46) eine Vielzahl getrennter und horizontal beabstandeter Auflageflächen (13, 23, 33, 43A, 43B) umfasst,
wobei die Anordnung derart ist, dass verwendete Werkstücke (W) entlang des horizontalen Transportpfades in die Druckmaschine hinein und durch diese hindurch befördert werden, der sich vertikal über dem Werkzeug (16, 26, 36, 46) befindet, wenn der höhenverstellbare Tisch (15, 25, 35, 45) in der eingefahrenen Position ist, und eine Auflagefläche (13, 23, 33, 43A, 43B) durch Anheben des höhenverstellbaren Tisches (15, 25, 35, 45) in Richtung der ausgefahrenen Position in Eingriff mit einem Werkstück (W) gebracht werden kann, um es zu ermöglichen, dass ein Druckvorgang durchgeführt wird, um das in Eingriff befindliche Werkstück (W) zu bedrucken,
wobei das Verfahren das Transportieren einer Vielzahl von zu bedruckenden Werkstücken (W) in die Druckmaschine hinein entlang des horizontalen Transportpfades umfasst,
wobei die Vielzahl von Auflageflächen entlang des horizontalen Transportpfades in einem zweiten Abstand beabstandet sind, der größer als der erste Abstand ist, und
der Transport so gesteuert wird, dass jedes Werkstück (W) der Vielzahl von Werkstücken (W) an einem entsprechenden ersten und zweiten Ort innerhalb der Druckmaschine angehalten wird, wobei der erste und der zweite Ort entlang des horizontalen Transportpfades beabstandet sind und jeweils direkt über dem höhenverstellbaren Tisch (15, 25, 35, 45), wenn er sich in eingefahrener Position befindet, positioniert sind, wobei mindestens einer aus dem ersten und dem zweiten Ort direkt über einer Auflagefläche (13, 23, 33, 43A, 43B) des Werkzeugs (16, 26, 36, 46) positioniert ist.

2. Verfahren nach Anspruch 1, wobei die zu bedruckenden Werkstücke (W) mindestens ein Werkstück (W) in einer ersten Anordnung und mindestens ein Werkstück (W) in einer zweiten Anordnung beinhalten, wobei die Werkstücke (W) der ersten und der zweiten Anordnung entlang des horizontalen Transportpfades verschachtelt sind, wobei das Verfahren die folgenden Schritte umfasst:
i) Steuern des Transports, um die Vielzahl von Werkstücken (W) entlang des horizontalen Transportpfades zu bewegen und ein Werkstück (W) der ersten Anordnung an einem ersten entsprechenden Ort anzuhalten, an dem es direkt über einer Auflagefläche (13, 23, 33, 43A, 43B) liegt, und ein Werkstück (W) der zweiten Anordnung an einem ersten entsprechenden Ort anzuhalten, an dem es direkt über dem höhenverstellbaren Tisch (15, 25, 35, 45) aber nicht über einer Auflagefläche (13, 23, 33, 43A, 43B) liegt,
ii) Anheben des höhenverstellbaren Tisches (15, 25, 35, 45), um das Werkstück (W) der ersten Anordnung in Eingriff mit seiner darunterliegenden Auflagefläche (13, 23, 33, 43A, 43B) zu bringen,
iii) Durchführen eines ersten Druckvorgangs, um das in Eingriff befindliche Werkstück (W) der ersten Anordnung zu bedrucken,
iv) Absenken des höhenverstellbaren Tisches (15, 25, 35, 45), um das Werkstück (W) der ersten Anordnung außer Eingriff mit der Auflagefläche (13, 23, 33, 43A, 43B) zu bringen,
v) Steuern des Transports, um die Vielzahl von Werkstücken (W) entlang des horizontalen Transportpfades zu bewegen und das Werkstück (W) der zweiten Anordnung an einem zweiten entsprechenden Ort anzuhalten, an dem es direkt über einer Auflagefläche (13, 23, 33, 43A, 43B) liegt, und das Werkstück (W) der ersten Anordnung an einem zweiten entsprechenden Ort anzuhalten, an dem es direkt über dem höhenverstellbaren Tisch (15, 25, 35, 45) aber nicht über einer Auflagefläche (13, 23, 33, 43A, 43B) liegt,
vi) Anheben des höhenverstellbaren Tisches (15, 25, 35, 45), um das Werkstück (W) der zweiten Anordnung in Eingriff mit seiner darunterliegenden Auflagefläche (13, 23, 33, 43A, 43B) zu bringen,
vii) Durchführen eines zweiten Druckvorgangs, um das in Eingriff befindliche Werkstück (W) in der zweiten Anordnung zu bedrucken,
viii) Absenken des höhenverstellbaren Tischs (15, 25, 35, 45), um das Werkstück (W) der zweiten Anordnung außer Eingriff mit der Auflagefläche (13, 23, 33, 43A, 43B) zu bringen.

3. Verfahren nach Anspruch 2, wobei ein Werkstück (W) der ersten Anordnung und ein Werkstück (W) der zweiten Anordnung auf einem gemeinsamen Träger (14, 34) in die Druckmaschine hinein befördert werden, und der Träger (14, 34) in Schritt i) entlang des horizontalen Transportpfades zu einem ersten Trägerort befördert wird, und der Träger (14, 34) in Schritt v) entlang des horizontalen Transportpfades zu einem zweiten Trägerort befördert wird.

4. Verfahren nach Anspruch 1, wobei eine Vielzahl von Anhalteorten entlang des horizontalen Transportpfades vorgesehen ist, und der Transport so gesteuert wird, dass jedes Werkstück (W) an einem ausgewählten entsprechenden Anhalteort angehalten wird, optional wird ein Werkstück (W) an jedem Anhalteort angehalten, und ein einziger Druckvorgang durchgeführt, um jedes Werkstück (W), das am Anhalteort angehalten wird, zu bedrucken.

5. Verfahren nach einem der vorstehenden Ansprüche, wobei das Werkzeug (16, 26, 36, 46) eine Vielzahl von Masten (12, 22, 32, 42) umfasst, wobei jede Auflagefläche (13, 23, 33, 43A, 43B) an einem oberen Ende eines entsprechenden Masten (12, 22, 32, 42) positioniert ist und jede Auflagefläche (13, 23, 33, 43A, 43B) innerhalb der horizontalen Ebene beweglich ist.

6. Verfahren nach Anspruch 5, wobei jede Auflagefläche (13, 23, 33, 43A, 43B) sowohl parallel zu dem horizontalen Pfad als auch orthogonal zu dem horizontalen Pfad innerhalb der horizontalen Ebene verschiebbar und um eine entsprechende vertikale Achse drehbar ist.

7. Verfahren nach Anspruch 5 oder 6, umfassend das Anhalten eines Werkstücks (W) an einem ersten Ort, in dem es direkt über einer ersten und einer zweiten Auflagefläche liegt, sodass das Anheben des höhenverstellbaren Tisches (15, 25, 35, 45) in Richtung der ausgefahrenen Position sowohl die erste als auch die zweite Auflagefläche (13, 23, 33, 43A, 43B) in Eingriff mit dem Werkstück (W) bringt.

8. Verfahren nach Anspruch 7, umfassend den Schritt des Anpassens der Position und / oder der Drehung des Werkstücks (W) durch Bewegen der ersten und der zweiten Auflagefläche (13, 23, 33, 43A, 43B), wenn diese mit dem Werkstück (W) in Eingriff sind.

9. Computerprogramm zum Steuern einer Druckmaschine, um das Verfahren nach einem der vorstehenden Ansprüche durchzuführen.

10. Druckmaschine zum Bedrucken von Werkstücken (W) mit einem ersten Abstand entlang eines horizontalen Transportpfades, umfassend:
einen höhenverstellbaren Tisch (15, 25, 35, 45), der vertikal zwischen einer unteren, eingefahrenen Position und einer oberen, ausgefahrenen Position beweglich ist,
Werkzeug, das an dem höhenverstellbaren Tisch (15, 25, 35, 45) angebracht ist, um darin getragen zu werden; wobei das Werkzeug eine Vielzahl getrennter und horizontal beabstandeter Auflageflächen (13, 23, 33, 43A, 43B) umfasst,
ein Förderband, das dazu betriebsfähig ist, Werkstücke entlang des horizontalen Pfades in die Druckmaschine hinein und durch diese hindurch zu transportieren, der sich vertikal über dem Werkzeug befindet, wenn der höhenverstellbare Tisch (15, 25, 35, 45) in der eingefahrenen Position ist, und
wobei die Vielzahl von Auflageflächen entlang des horizontalen Transportpfades in einem zweiten Abstand beabstandet sind, der größer als der erste Abstand ist, und
wobei die Druckmaschine ferner ein Transportsteuersystem umfasst, das dazu betriebsfähig ist, ein Werkstück (W) auf dem Förderband selektiv entweder an einem ersten oder an einem zweiten Ort innerhalb der Druckmaschine anzuhalten, wobei der erste und der zweite Ort entlang des horizontalen Transportpfade beabstandet sind und jeweils direkt über dem höhenverstellbaren Tisch (15, 25, 35, 45), wenn er sich in eingefahrener Position befindet, positioniert sind, wobei mindestens einer aus dem ersten und dem zweiten Ort direkt über einer Auflagefläche (13, 23, 33, 43A, 43B) des Werkzeugs positioniert ist.

11. Druckmaschine nach Anspruch 10, wobei das Transportsteuersystem Folgendes umfasst:
ein erstes physisches Anhalteelement (17), das dazu betriebsfähig ist, ein Werkstück (W) an dem ersten Ort anzuhalten, und
ein zweites physisches Anhalteelement (18), das dazu betriebsfähig ist, ein Werkstück (W) an dem zweiten Ort anzuhalten.

12. Druckmaschine nach Anspruch 10, wobei das Transportsteuersystem Folgendes umfasst:
eine Förderbandsteuerung, die dazu betriebsfähig ist, den Betrieb des Förderbands zu steuern, um ein Werkstück (W) an einem ausgewählten Ort aus dem ersten und dem zweiten Ort zum Anhalten zu bringen.

13. Druckmaschine nach Anspruch 12, wobei das Transportsteuersystem Folgendes umfasst:
einen Sensor, der jeweils dem ersten und dem zweiten Ort zugeordnet ist, um das Vorhandensein eines Werkstücks (W) auf dem Förderband vorgelagert zu dem entsprechenden Ort zu erfassen und ein Signal, das dieses Vorhandensein anzeigt, an die Förderbandsteuerung weiterzugeben.

14. Verfahren zum Ausrichten eines Werkstücks (W) zum Bedrucken innerhalb einer Druckmaschine, die Druckmaschine umfassend:
einen höhenverstellbaren Tisch (45), der vertikal zwischen einer unteren, eingefahrenen Position und einer oberen, ausgefahrenen Position beweglich ist, und
Werkzeug (46), das an dem höhenverstellbaren Tisch (45) angebracht ist, um darin getragen zu werden; wobei das Werkzeug (46) eine Vielzahl getrennter und horizontal beabstandeter Auflageflächen (43A, 43B) umfasst, wobei das Werkzeug (46) eine Vielzahl von Masten (42) umfasst, wobei jede Auflagefläche der Vielzahl von Auflageflächen (43A, 43B) an einem oberen Ende eines entsprechenden Masten (42) positioniert ist und jede Auflagefläche (43A, 43B) innerhalb der horizontalen Ebene beweglich ist, und wobei jeder Mast (42) einzeln betätigbar ist, um seine Auflagefläche (43A, 43B) sowohl parallel als auch orthogonal zu dem horizontalen Pfad innerhalb der horizontalen Ebene zu verschieben und die Auflagefläche (43A, 43B) um eine entsprechende Achse zu drehen,
wobei das Verfahren die folgenden Schritte umfasst:
i) Transportieren eines Werkstücks (W) entlang eines horizontalen Transportpfades in die Druckmaschine hinein und durch diese hindurch,
ii) Anhalten des Werkstücks (W) an einem Ort, in dem das Werkstück (W) direkt über einer ersten und einer zweiten Auflagefläche der Vielzahl von Auflageflächen (43A, 43B) liegt,
iii) Ineingriffbringen des Werkstücks (W) mit sowohl der ersten als auch der zweiten Auflagefläche (43A, 43B), und
iv) Ausrichten des Werkstücks (W) durch Bewegen der ersten und der zweiten Auflagefläche (43A, 43B), während diese mit dem Werkstück (W) in Eingriff sind.

## Revendications

1. Procédé d'impression de pièces de travail (W) ayant un premier pas le long d'un trajet de transport horizontal utilisant une machine d'impression, la machine d'impression comprenant :
une table montante (15, 25, 35, 45) étant mobile verticalement entre une position rétractée inférieure et une position étendue supérieure, et
outillage (16, 26, 36, 46) fixé à la table montante (15, 25, 35, 45) pour être transporté avec elle, l'outillage (16, 26, 36, 46) comprenant une pluralité de surfaces de support (13, 23, 33, 43A, 43B) discrètes et espacées horizontalement,
l'agencement étant tel qu'en utilisation, les pièces de travail (W) sont acheminées dans et à travers la machine d'impression le long du trajet de transport horizontal, qui est verticalement au-dessus de l'outillage (16, 26, 36, 46) lorsque la table montante (15, 25, 35, 45) est dans la position rétractée, et une surface de support (13, 23, 33, 43A, 43B) peut être mise en prise avec une pièce de travail (W) en soulevant la table montante (15, 25, 35, 45) vers la position étendue, pour permettre à une opération d'impression d'être réalisée afin d'imprimer la pièce de travail (W) mise en prise,
le procédé comprenant le transport d'une pluralité de pièces de travail (W) à imprimer dans la machine d'impression le long du trajet de transport horizontal,
dans lequel la pluralité de surfaces de support sont espacées le long du trajet de transport horizontal d'un second pas qui est supérieur au premier pas, et
le transport est commandé de telle sorte que chaque pièce de travail (W) de la pluralité de pièces de travail (W) est arrêtée au niveau de premier et second emplacements respectifs dans la machine d'impression, les premier et second emplacements étant espacés le long du trajet de transport horizontal et chacun étant situé directement au-dessus de la table montante (15, 25, 35, 45) lorsqu'elle est dans sa position rétractée, avec au moins l'un des premier et second emplacements étant directement situé au-dessus d'une surface de support (13, 23, 33, 43A, 43B) de l'outillage (16, 26, 36, 46).

2. Procédé selon la revendication 1, dans lequel les pièces de travail (W) à imprimer incluent au moins une pièce de travail (W) d'une première série, et au moins une pièce de travail (W) d'une seconde série, les pièces de travail (W) des première et seconde séries étant intercalées le long du trajet de transport horizontal, le procédé comprenant les étapes de :
i) commande du transport pour déplacer la pluralité de pièces de travail (W) le long du trajet de transport horizontal et arrêter une pièce de travail (W) de la première série au niveau d'un premier emplacement respectif dans lequel elle repose directement sur une surface de support (13, 23, 33, 43A, 43B), et arrêter une pièce de travail (W) de la seconde série au niveau d'un premier emplacement respectif dans lequel elle repose directement sur la table montante (15, 25, 35, 45) mais pas sur une surface de support (13, 23, 33, 43A, 43B),
ii) soulèvement de la table montante (15, 25, 35, 45) pour mettre la pièce de travail (W) de la première série en prise avec sa surface de support (13, 23, 33, 43A, 43B) sous-jacente,
iii) réalisation d'une première opération d'impression pour imprimer la pièce de travail (W) mise en prise de la première série,
iv) abaissement de la table montante (15, 25, 35, 45) pour amener la pièce de travail (W) imprimée de la première série hors prise avec la surface de support (13, 23, 33, 43A, 43B),
v) commande du transport pour déplacer la pluralité de pièces de travail (W) le long du trajet de transport horizontal et arrêter la pièce de travail (W) de la seconde série au niveau d'un second emplacement respectif dans lequel elle repose directement sur une surface de support (13, 23, 33, 43A, 43B), et arrêter la pièce de travail (W) de la première série au niveau d'un second emplacement respectif dans lequel elle repose directement sur la table montante (15, 25, 35, 45) mais pas sur une surface de support (13, 23, 33, 43A, 43B),
vi) soulèvement de la table montante (15, 25, 35, 45) pour mettre la pièce de travail (W) de la seconde série en prise avec sa surface de support (13, 23, 33, 43A, 43B) sous-jacente,
vii) réalisation d'une seconde opération d'impression pour imprimer la pièce de travail (W) mise en prise de la seconde série, et
viii) abaissement de la table montante (15, 25, 35, 45) pour amener la pièce de travail (W) imprimée de la seconde série hors prise avec la surface de support (13, 23, 33, 43A, 43B).

3. Procédé selon la revendication 2, dans lequel une pièce de travail (W) de la première série et une pièce de travail (W) de la seconde série sont acheminées dans la machine d'impression sur un support (14, 34) commun, et dans l'étape i) le support (14, 34) est transporté vers un premier emplacement de support le long du trajet de transport horizontal, et dans l'étape v) le support (14, 34) est transporté vers un second emplacement de support le long du trajet de transport horizontal.

4. Procédé selon la revendication 1, dans lequel une pluralité d'emplacements d'arrêt sont prévus le long du trajet de transport horizontal, et le transport est commandé de telle sorte que chaque pièce de travail (W) est arrêtée au niveau d'un emplacement d'arrêt respectif sélectionné ; éventuellement une pièce de travail (W) est arrêtée au niveau de chaque emplacement d'arrêt, et une opération d'impression unique est réalisée pour imprimer chaque pièce de travail (W) qui est arrêtée au niveau d'un emplacement d'arrêt.

5. Procédé selon une quelconque revendication précédente, dans lequel l'outillage (16, 26, 36, 46) comprend une pluralité de tours (12, 22, 32, 42), chaque surface de support (13, 23, 33, 43A, 43B) étant située au niveau d'une extrémité supérieure d'une tour (12, 22, 32, 42) respective, et chaque surface de support (13, 23, 33, 43A, 43B) est mobile dans le plan horizontal.

6. Procédé selon la revendication 5, dans lequel chaque surface de support (13, 23, 33, 43A, 43B) peut translater à la fois parallèlement au trajet horizontal et orthogonalement au trajet horizontal dans le plan horizontal, et peut tourner autour d'un axe vertical respectif.

7. Procédé selon l'une ou l'autre des revendications 5 et 6, comprenant l'arrêt d'une pièce de travail (W) au niveau d'un premier emplacement dans lequel elle repose directement sur les première et seconde surfaces de support, de telle sorte que le soulèvement de la table montante (15, 25, 35, 45) vers la position étendue met à la fois les première et seconde surfaces de support (13, 23, 33, 43A, 43B) en prise avec la pièce de travail (W).

8. Procédé selon la revendication 7, comprenant l'étape d'ajustement de la position et/ou de la rotation de la pièce de travail (W) par déplacement des première et seconde surfaces de support (13, 23, 33, 43A, 43B) lorsqu'elles sont en prise avec la pièce de travail (W).

9. Programme informatique destiné à commander une machine d'impression pour réaliser le procédé selon une quelconque revendication précédente.

10. Machine d'impression destinée à imprimer des pièces de travail (W) ayant un premier pas le long du trajet de transport horizontal, comprenant :
une table montante (15, 25, 35, 45) étant mobile verticalement entre une position rétractée inférieure et une position étendue supérieure,
outillage fixé à la table montante (15, 25, 35, 45) pour être transporté avec elle, l'outillage comprenant une pluralité de surfaces de support (13, 23, 33, 43A, 43B) discrètes et espacées horizontalement,
une bande transporteuse servant à transporter des pièces de travail dans et à travers la machine d'impression le long du trajet de transport horizontal, qui est verticalement au-dessus de l'outillage lorsque la table montante (15, 25, 35, 45) est dans la position rétractée, et
dans laquelle la pluralité de surfaces de support sont espacées le long du trajet de transport horizontal d'un second pas qui est supérieur au premier pas, et
la machine d'impression comprenant en outre un système de commande de transport servant à arrêter sélectivement une pièce de travail (W) sur la bande transporteuse au niveau de l'un ou l'autre d'un premier ou d'un second emplacement dans la machine d'impression, les premier et second emplacements étant espacés le long du trajet de transport horizontal et chacun étant situé directement au-dessus de la table montante (15, 25, 35, 45) lorsqu'elle est dans sa position rétractée, avec au moins l'un des premier et second emplacements étant directement situé au-dessus d'une surface de support (13, 23, 33, 43A, 43B) de l'outillage.

11. Machine d'impression selon la revendication 10, dans laquelle le système de commande de transport comprend :
un premier élément d'arrêt physique (17) servant à arrêter une pièce de travail (W) au niveau du premier emplacement, et
un second élément d'arrêt physique (18) servant à arrêter une pièce de travail (W) au niveau du second emplacement.

12. Machine d'impression selon la revendication 10, dans laquelle le système de commande de transport comprend :
une commande de bande transporteuse servant à commander le fonctionnement de la bande transporteuse pour amener une pièce de travail (W) vers un arrêt au niveau de l'un sélectionné des premier et second emplacements.

13. Machine d'impression selon la revendication 12, dans laquelle le système de commande de transport comprend :
un capteur associé à chacun des premier et second emplacements pour détecter la présence d'une pièce de travail (W) sur la bande transporteuse en amont de l'emplacement respectif et pour transférer un signal indiquant une telle présence à la commande de bande transporteuse.

14. Procédé d'alignement d'une pièce de travail (W) pour l'impression dans une machine d'impression, la machine d'impression comprenant :
une table montante (45) étant mobile verticalement entre une position rétractée inférieure et une position étendue supérieure, et
outillage (46) fixé à la table montante (45) pour être transporté avec elle, l'outillage (46) comprenant une pluralité de surfaces de support (43A, 43B) discrètes et espacées horizontalement, dans lequel l'outillage (46) comprend une pluralité de tours (42), chaque surface de support de la pluralité de surfaces de support (43A, 43B) étant située au niveau d'une extrémité supérieure d'une tour (42) respective, et chaque surface de support (43A, 43B) est mobile dans le plan horizontal, et dans lequel chaque tour (42) est actionnable individuellement pour faire translater sa surface de support (43A, 43B) à la fois parallèlement au trajet horizontal et orthogonalement au trajet horizontal dans le plan horizontal, et pour faire tourner la surface de support (43A, 43B) autour d'un axe vertical respectif,
dans lequel le procédé comprend les étapes de :
i) transport d'une pièce de travail (W) dans et à travers la machine d'impression le long d'un trajet de transport horizontal,
ii) arrêt de la pièce de travail (W) au niveau d'un emplacement dans lequel la pièce de travail (W) repose directement sur les première et seconde surfaces de support de la pluralité de surfaces de support (43A, 43B),
iii) mise en prise de la pièce de travail (W) à la fois avec les première et seconde surfaces de support (43A, 43B), et
iv) alignement de la pièce de travail (W) en déplaçant les première et seconde surfaces de support (43A, 43B) alors qu'elles sont en prise avec la pièce de travail (W).
